# EUROPEAN PATENT APPLICATION

(11) **EP 2 113 953 A1**
(43) Date of publication of application: **04.11.2009**
(21) Application number: 08251565.1
(22) Date of filing: 30.04.2008
(51) Int. Cl.: H01L 41/113, B60C 23/04

(54) **Improvements in or relating to energy conversion**

(71) Applicant: Silicon Sensing Systems Limited, Clittaford Road Southway, Plymouth Devon, PL6 6DE (GB)
(72) Inventor: Malvern, Alan Richard, Plymouth PL6 6DE (GB); Thomas, Henry James, Plymouth PL6 6DE (GB)
(74) Representative: Bingham, Ian Mark

(57) **Abstract**

An apparatus 30 for generation of electrical energy under centrifugal force includes a beam 32 attached at a first end 34 to a support 36 such that the beam 32 is cantilevered with respect to the support 36. A loading mass 38 is attached to the beam 32 towards a distal end 40 of the beam 32. A piezoelectric element 42 is bonded to the beam 32 such that it will act in compression when a centrifugal force is applied to the loading mass 38.

Deflection of the loading mass 38 under centrifugal force causes stress within the piezoelectric element 42 which in turn creates an electrical charge proportional to the integrated stress along the length of the piezoelectric element 42.

## Description

The present invention relates to an apparatus for generation of electrical energy under centrifugal force and to a monitor system for monitoring at least one parameter of a node remote from a central unit.

Tyre pressure monitoring systems typically include a central processor for a vehicle wireless coupled to a sensor within one or more of the tyres of the vehicle. The sensor within the tyre requires a power source to measure the pressure of the tyre and to transmit the measurement to the central processor. Battery power can be utilised to provide electrical energy to the sensor. However, it is also possible to provide electrical energy via an energy generator mounted within the tyre that uses the motion of the tyre as it contacts the road to generate electrical energy. It will be understood that a tyre rotating on a road surface will be subject to vibration and shock and that the energy generator can use this movement to generate electrical energy.

The pressure measurement provide by the sensor is used by the central processor for applications wherein the pressure of the tyres will affect the performance or handling of the vehicle, for example electronic stability programme (ESP) or anti-lock brake systems (ABS). An alarm can also be provided to the operator of the vehicle if the pressure of a tyre is lower than a defined safe limit.

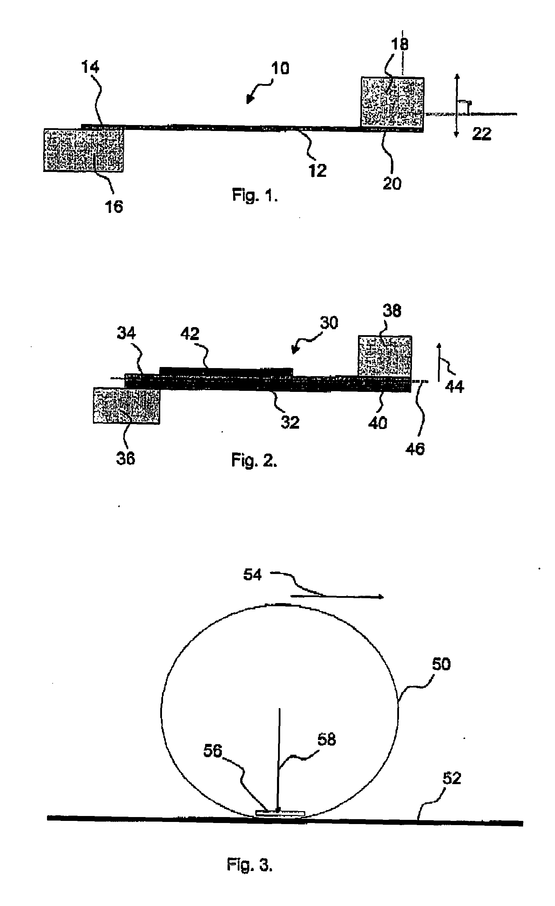

Referring to Figure 1, a known energy generator 10 comprises a bimorph piezoelectric element 12 fixed at a first end 14 to a mount 16 to provide a cantilevered piezoelectric element 12 and a brass proof mass 18 is located at a free end 20 of the piezoelectric element 12. The bimorph piezoelectric element 12 comprises two active layers of piezoelectric material. In this manner, when the proof mass 18 is subjected to vibration, indicated by arrow 22, the piezoelectric element 12 acts as a bimorph device, since the vibration causes the piezoelectric element 12 to act in compression when an upward force is applied to the proof mass 18 and to act in tension when a downward force is applied to the proof mass 18. Accordingly, the piezoelectric element 12 generates a charge both when tension and compression is applied to the piezoelectric element 12. Thus, the voltages or currents produced by each layer of piezoelectric material can be added to one another in either series or parallel.

Generated energy is then used to charge a storage capacitor through a rectifier bridge. The storage capacitor in turn is used to provide electrical energy to electronic components, for example a sensor. Such a device can be used in the tyre pressure monitoring system, wherein the electronic components of a pressure sensor are positioned within a tyre and are required to communicate with a central computer of a vehicle. The electronic components are coupled to the storage capacitor and provided with electrical energy as appropriate.

At low speeds, for example, under 20km/hour, the tyre pressure monitoring system needs to be provided with electrical energy from an associated storage capacitor as quickly as possible, such that the central computer of the vehicle carrying the tyre pressure monitoring system can be notified of under-inflation of a tyre before the vehicle travels too far. Typically, the storage capacitor needs to be charged to four volts in less than thirty seconds. Once the storage capacitor reaches four volts, electrical energy is provided to the tyre pressure monitoring system, which measures and transmits data to the central computer via a radio channel. The storage capacitor discharges during transmission of data such that the charge cycle can be repeated.

EP1700351 teaches a tyre comprising a piezoelectric flexing element associated to an energy storage device, for example a capacitor. The piezoelectric flexure element is mounted in cantilever fashion in a housing so as to be positioned substantially along a plane orthogonal to a radial direction of the tyre and, so that a first end of the piezoelectric element is restrained by the housing. A loading mass is coupled to a second end of the piezoelectric element. A small gap is formed between the inner walls of the housing and the outer surface of the loading mass, in order to allow limited flexure of the piezoelectric element. The housing is mounted in a tyre portion so as to correspond with a tread area of the tyre, preferably on the inner surface of the tyre. The piezoelectric element flexes under the action of the radial acceleration when the tyre rotates. The loading mass and the gap are chosen such that energy is either generated at a low tyre speed during the entire revolution of the tyre or at a higher speed, but only when the tyre portion to which the housing is attached is in contact with the road. That is, energy is not generated at higher speeds when the tyre portion to which the housing is attached is not in contact with the ground. Sufficient electrical power for powering an electronic device included within the tyre is thereby obtained when the rotational speed of the tyre reaches a predefined speed.

According to a first aspect of the invention, an apparatus for generation of electrical energy under centrifugal force, includes: a support; a beam attached at a first end to the support; a loading mass attached to a distal end of the beam such that the loading mass is cantilevered with respect to the support; a piezoelectric element attached to a surface of the beam; and wherein the piezoelectric element is attached to the beam such that the piezoelectric element will be compressed by a centrifugal force applied to the loading mass.

A first bump stop element may be arranged to contact the beam when the piezoelectric element is subjected to a predetermined compression force. The first bump stop element may be arranged to gradually contact the beam along the length of the beam with increasing compression force. Alternatively, the first bump stop element may include two or more contact regions arranged to contact the beam along the length of the beam each at a different predetermined compression load.

A second bump stop element may be arranged to contact the beam when the piezoelectric element is subjected to a predetermined tension force-The second bump stop element may be arranged to gradually contact the beam along the length of the beam with increasing tension force. Alternatively, the second bump stop element may include two or more contact regions arranged to contact the beam along the length of the beam each at a different predetermined tension load.

A gap between the second bump stop element and the beam may be smaller than the gap between the first bump stop element and the beam.

The beam may be formed from silicon. The beam may be bonded to the support. The piezoelectric element may be bonded to the beam.

The beam may include at least one shim carried thereon and the shim may be arranged to contact the first and/or the second bump stop element. The first and/or the second bump stop element may include a region of compliant material arranged to contact the beam. Alternatively, the beam may include at least one region of compliant material arranged to contact the first and/or the second bump stop element.

The beam may be tapered between the first end and the distal end. The beam may have a substantially T-shaped cross section.

The piezoelectric element may be tapered between the first end and the distal end.

An apparatus for generation of electrical energy under centrifugal force may be arranged to be electrically connected to a tyre pressure monitoring system.

According to another aspect of the invention, a monitor system for monitoring at least one parameter at a node remote from a central unit, includes an apparatus for generation of electrical energy under centrifugal force, a sensor device associated with the node and electrically connected to the apparatus for generation of electrical energy under centrifugal force that includes a measurement device arranged to measure the at least one parameter, a transmitter arranged to transmit a signal indicative of the parameter determined by the measurement device and a receiver associated with the central unit arranged to receive the signal from the transmitter.

For example, the remote node may be located within a tyre and arranged to monitor an operating parameter of the tyre and transmit a signal indicative of the operating parameter to a central processor of.a vehicle. The operating parameter may include tyre pressure.

The invention will now be described, by way of example only, with reference to the accompanying drawings, in which:
Figure 1 illustrates, In elevation, an energy generator according to the prior art;
Figure 2 illustrates, in elevation, an energy generator according to the present invention;
Figure 3 illustrates, in elevation, a vehicle tyre including an energy generator according to the present invention affixed thereto;
Figure 4 illustrates, in elevation, an energy generator according to the present invention in operation;
Figure 5 illustrates an energy generator according to the present invention;
Figure 6 illustrates, in exploded view, the energy generator of Figure 5;
Figure 7 illustrates, in elevation, the energy generator of Figures 5 and 6;
Figure 8 illustrates, in plan view, a tapered beam for an energy generator according to the present invention;
Figure 9 illustrates, in cross-sectional view, a T-shaped beam for an energy generator according to the present invention; and
Figure 10 illustrates, in elevation, an energy generator with regions of compliant material and shims.

Referring to Figure 1, although charge can be generated by the piezoelectric element 12 of the prior art in both tension and compression during a vibration cycle, the maximum stress that can be applied to the piezoelectric element 12 is limited by the strength of the piezoelectric element 12 whilst in tension to maintain the integrity of the piezoelectric element 12. For example, the piezoelectric element 12 will need to be limited to a stress less than 80MPa in tension to prevent damage to the piezoelectric element 12. This is considerable lower than the stress limit for the piezoelectric element 12 whilst in compression, for example 600MPa.

Referring to Figure 2, an apparatus 30 for generation of electrical energy under centrifugal force includes a beam 32 attached at a first end 34 to a support 36 such that the beam 32 is cantilevered with respect to the support 36. The beam 32 can be formed from silicon. A loading mass 38 is attached to the beam 32 towards a distal end 40 of the beam 32.

A piezoelectric element 42 is bonded to the beam 32 such that it will act in compression when a centrifugal force is applied to the loading mass 38. The beam 32 can be approximately 0.5mm thick and the piezoelectric element 42 can be approximately 0.3mm thick.

Deflection of the loading mass 38 causes stress within the piezoelectric element 42 which in turn creates an electrical charge proportional to the integrated stress along the length of the piezoelectric element 42. Deflection of the loading mass 38 is indicated by arrow 44. Deflection of the loading mass 38 can also be caused by vibration of a tyre to which the apparatus 30 is attached as the tyre makes contact with the road over which the tyre is rolling and shock due to the tyre flattening at the point of contact with the road surface.

The stress applied to the piezoelectric element 42 is dependant on the distance of the piezoelectric element 42 from the neutral axis 46 of the beam 32 and piezoelectric element 42 combination. By the suitably dimensioning the thickness of the beam 32 and the piezoelectric element 42, it is possible to ensure that the piezoelectric element 42 is presented with the same sign of stress throughout the thickness of the piezoelectric element 42. The stress throughout the piezoelectric element 42 increases from the surface of the piezoelectric element 42 in contact with the beam 32 and the surface of the piezoelectric element 42 remote from the beam 32. Accordingly, more stress can be applied to the piezoelectric element 42 by placing the piezoelectric element 42 further from the neutral axis 56.

However, it is know that a piezoelectric element 42 is a brittle material and that such material has a low breaking strength, especially in tension. Typically the breaking stress of such a piezoelectric element 42 is approximately 80MPa in tension and 600MPa in compression. Thus, the higher the stress applied to the piezoelectric element 42 the greater the chance of damaging the piezoelectric element 42. Therefore, there is a design balance between achieving a sufficient generated charge from the piezoelectric element 42 whilst maintaining a sufficiently low breaking stress on the piezoelectric element 42 to achieve a suitable operating life.

Referring to Figure 3, a tyre 50 rotates on a road surface 52 along the direction of travel indicated by arrow 54. The apparatus 30 of Figure 2 is mounted within the inside of the tyre 50 as generally indicated by housing 56. The centrifugal force applied to the rotating tyre acts radially outwards from the centre of the tyre as indicated by arrow 58. Accordingly, it will be observed that a centrifugal force acts upon the housing 56 thereby applying compression stress to a piezoelectric element 42 within the housing 56.

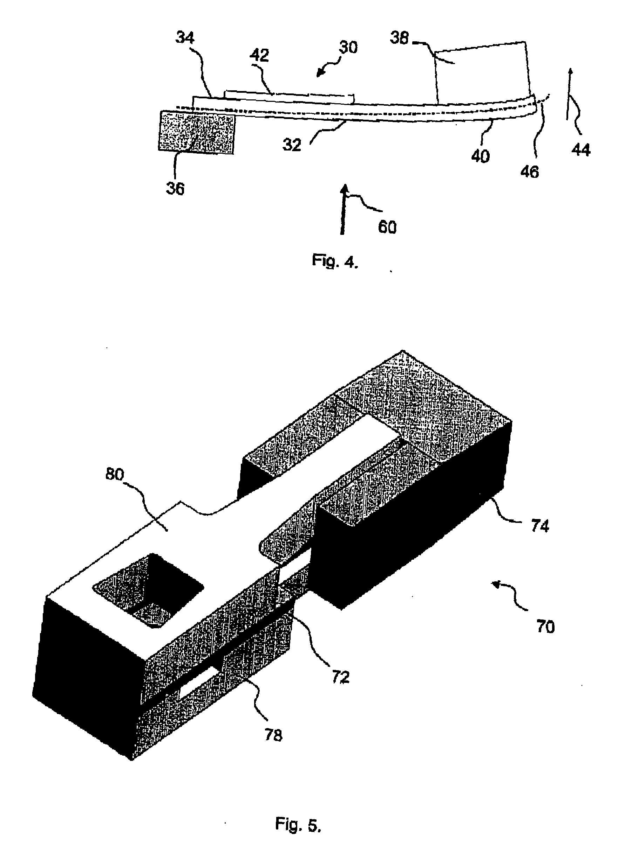

Referring to Figure 4, wherein like references have been used to indicated similar integers to those illustrated with reference to Figure 2, by appropriate orientation of the beam 32 it is possible to ensure that the centrifugal force acts on the loading mass 38 to push the piezoelectric element 42 into compression. Arrow 60 indicates the radial outward direction of a tyre to which the apparatus 30 is attached thereby causing centrifugal acceleration on the loading mass 38 as indicated by arrow 44. The piezoelectric element 42 is thereby held in compression as centrifugal force is applied by the rotation of the tyre.

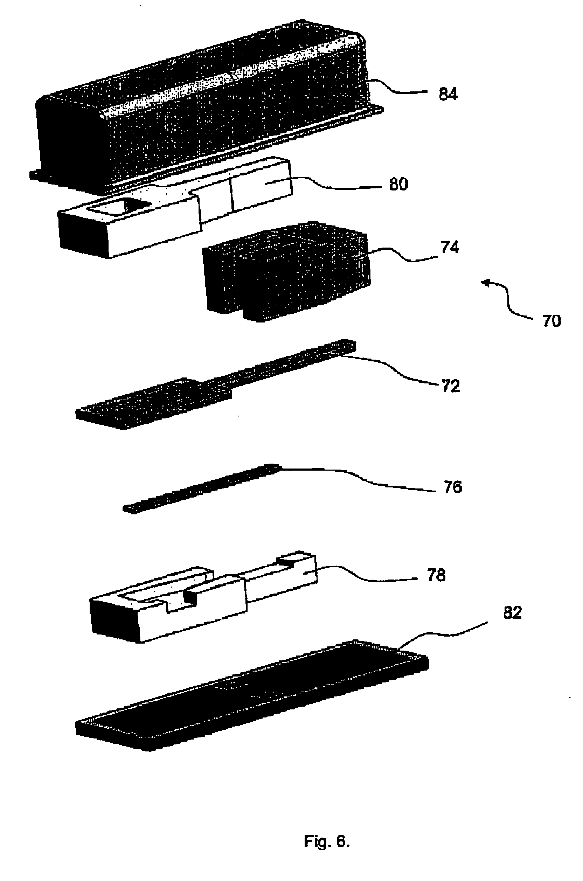

Referring to Figures 5 and 6, wherein like references are used to indicate similar integers, an apparatus 70 for generation of electrical energy under centrifugal force includes a beam 72 having a loading mass 74 mounted to one end thereof and a piezoelectric element 76 bonded to the beam 72.

Under tyre vibration at high speeds there will be a large centrifugal force, typically up to 4,000 g at a speed of 300km/hour. This can cause large deflections of the loading mass 74 that could overstress the piezoelectric element 76 in either compression or tension. Accordingly, a first bump stop element 78 is arranged on the side of the beam 72 to which the piezoelectric element 76 is mounted. The first bump stop element 78 is arranged to contact the beam 72 when the piezoelectric element 76 is subjected to a predetermined compression force as caused by centrifugal force on the loading mass 74.

The first bump stop element 78 can be arranged or profiled to gradually contact the beam 72 along the length of the beam 72 with increasing compression force so as to allow the beam 72 to apply a limited stress to the piezoelectric element 76 as high centrifugal force is applied. Alternatively, the first bump stop element 78 can include two or more contact regions arranged to contact the beam 72 along the length of the beam 72 each for a different predetermined compression force applied to the piezoelectric element 76. Hence, when a first predefined compression force is reached, the beam 72 will make contact with a first contact region of the first bump stop element 78 so as to limit the stress on the piezoelectric element 76 and when a second predefined compression force is reached the beam 72 will make contact with a second contact region of the first bump stop element 78 to further inhibit stress applied to the piezoelectric element 76. It will be understood that more than two contact regions can be sited to provide a stepped bump stop protection of the piezoelectric element 76 with increasing applied compression force.

A second bump stop element 80 can be arranged on the opposite side of the beam 72 remote from the piezoelectric element 76 and arranged to contact the beam 72 when the piezoelectric element 76 is subjected to a predetermined tension force.

Again, a second bump stop element 80 can be arranged or profiled to gradually contact the beam 72 along the length of the beam 72 as increasing tension force is applied to the piezoelectric element 76. Alternatively, the second bump stop element 80 can include two or more contact regions arranged to contact the beam 72 along the length of the beam 72 each for a different predetermined tension load. This will allow the piezoelectric element 76 to have a first predefined tension load applied until it contacts a first contact region of the second bump stop element 80 and allows the beam 72 to move in a limited manner until a second predetermined tension load is applied to the piezoelectric element 76 and the beam 72 contacts the second contact region of the second bump stop element 80. It will be understood that more than two contact regions can be sited to provide a stepped bump stop protection of the piezoelectric element 76 with increasing applied tension force.

The bump stop elements 78, 80 can be made from glass, silicon or a ceramic material.

The apparatus 70 is mounted on a mounting base 82 and enclosed by a lid element 84 arranged to enclose the apparatus 70 within the space formed by the mounting base 82 and lid element 84. The various elements can be bonded together.

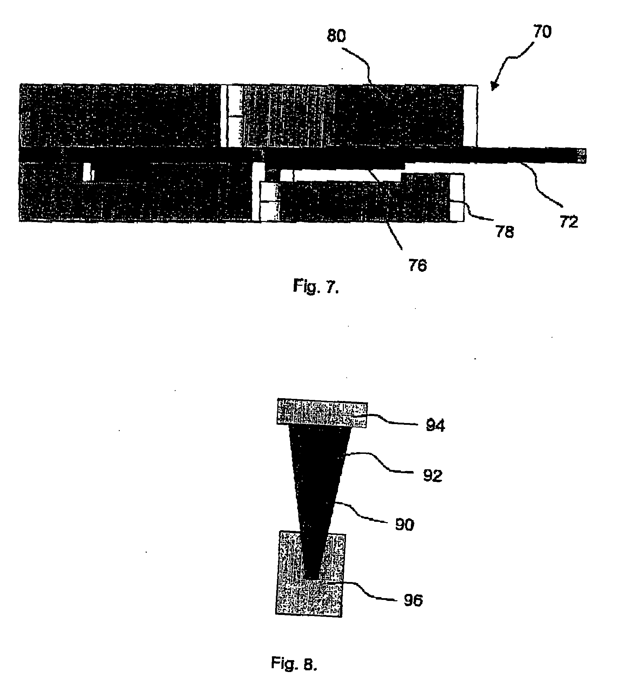

Referring to Figure 7, wherein like references have been used to indicate similar integers to those illustrated with reference to Figures 5 and 6, it will observed that the spacing between the second bump stop element 80 and the beam 72 is smaller than the space between the first bump stop element 78 and the beam 72. The larger spacing between the beam 72 and the first bump stop element 78 allows higher stress levels to be applied to the piezoelectric element 76 whilst in compression, typically up to 600MPa, whilst the smaller spacing between the beam 72 and second bump stop element 80 allows a limited stress level to be applied to the piezoelectric element 76 when in tension, typically up to 80MPa. The spacing can be computed to ensure that the maximum stress applied to the piezoelectric element 76 before contact with either the first or second bump stop elements 78, 80 is a fraction of the breaking stress of the piezoelectric element 76. This will ensure long term survival of the piezoelectric element 76.

To generate maximum electrical energy from the piezoelectric element 76, the compression stress along the length of the piezoelectric element 76 should be as uniform as possible. Referring to Figure 8, uniform stress can be applied to a piezoelectric element 90 using a tapered beam 92 having its widest portion bonded to a mounting 74 and a loading mass 96 applied to the narrower end of the tapered beam 92.

With the tapered beam 92, the curvature of the tapered beam 92 is more uniform along its length when a centrifugal force is applied to the loading mass 96 so that the stress applied to the piezoelectric element 90 is also more uniform. This results in higher stress levels on the piezoelectric element 92 and hence the generation of more energy from the piezoelectric element 90 as it is the integral of the stress along the length of the piezoelectric element 90 that provides the overall voltage generated by the piezoelectric element 90.

The tapered beam 92 also ensures that the stress at the point of engagement with the mounting 94 is lower than that for a rectangular shaped beam. Accordingly it is less likely to break at the mounting 74.

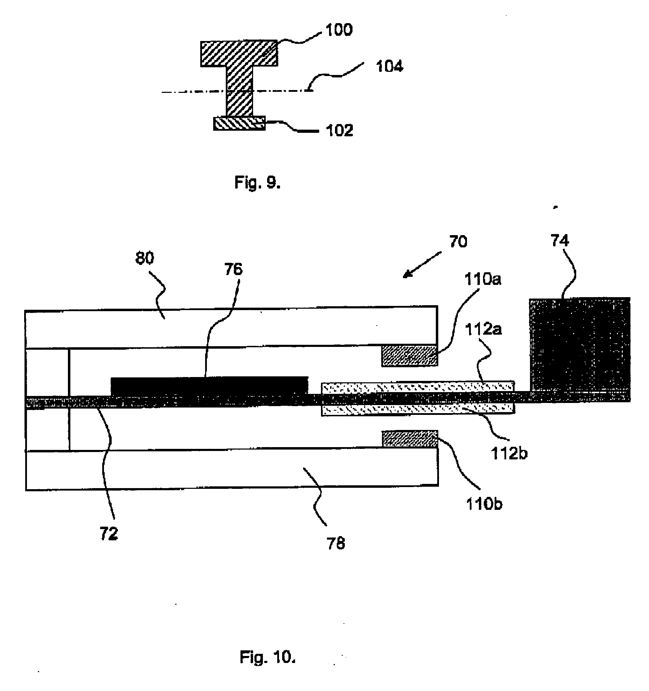

Referring to Figure 9, the cross-section of a beam 100 can be substantially T-shaped with a piezoelectric element 102 mounted to one limb of the T-section beam 100. In this manner, the neutral axis 104 of the beam 100 and piezoelectric element 102 combination can be located further away from the piezoelectric element 102, thereby producing more stress on the piezoelectric element 102 to generate a greater charge from the piezoelectric element 102. The overhanging of the piezoelectric element 102 over the edges of the T-shaped beam 100 serves to reduce the resonant frequency of the beam 102.

Generally, the upper and lower surfaces of the piezoelectric element are metallised to form electrodes that are then coupled to a suitable charge storing device, for example a capacitor. The charge storing device can be electrically connected to a sensor within the tyre that measures one or more parameters of the tyre, for example air pressure of the tyre, and transmits such a measurement to a central computer of the vehicle.

Furthermore, the beam can be manufactured by deep reactive ion beam etching (DRIE) of a silicon material used to form the beam at a wafer scale to manufacture a large number of parts at the same time for a low cost device. DRIE is a dry etching process that ensures a very good quality of the edges of the beam and this is important so as to increase the breaking strength of the beam. A wet etch process can also be used which results in a cheaper process. However, such etching is limited to certain crystal planes of the silicon material and may not give the strongest beam. Alternatively, the beam may be formed from metal and can be stamped to give the desired beam shape.

In the present invention, it is the beam itself that impacts the first or second bump stop elements and not the loading mass. The first and second bump stop elements are approximately mounted at the centre of the mass of the loading mass so that there will be a reduced further bending of the beam when the beam contacts either the first or second bump stop element.

Referring to Figure 10, wherein like references have been used to indicate similar integers to those illustrated with reference to Figures 5 to 7, either the first or the second or both bump stop elements 78, 80 can include a layer of compliant material 110a, 110b arranged to contact the silicon beam 72. The layer of compliant material 110a, 110b is formed from a material that is softer than the material used to form the beam 72. In this manner, the beam 72 is protected from impact or abrasion with the relevant bump stop element 78, 80 by the associated layer of compliant material 110a, 110b when the loading mass 74 moves under the influence of an applied centrifugal force and hence the beam 72 is brought into contact with a bump stop element 78, 80. It will be noted that during silicon to silicon contact, i.e. the beam 72 contacting on a bump stop elements 78, 80, a chipping process can occur that can result in weakening and eventual failure of the beam 72. The chipping process can generate loose particles of silicon that can also form an abrasive material that can damage the silicon of the beam 72. The strength of the beam 72 is dependent on the surface quality of the beam 72, such that chipping of the surface of the beam 72 can reduce fracture strength, which can result in failure of the beam 72. An elastomer silicone material can be used to form the layers of compliant material 110a, 110b.

A photo-sensitive compliant film can be applied to the bump stop element 78, 80 at wafer level with a subsequent photo and etching process to provide a precise and low cost method of manufacturing the layers of compliant material 110a, 110b on the bump stop elements 78, 80.

Furthermore, either as an alternative to the provision of a layer of compliant material 110a, 110b to the bump stop elements 78, 80 or as a further feature, at least one shim 112a, 112b can be carried by the beam 72. In this example two shims 112a, 112b can be arranged to contact the associated bump stop element 78, 80 or, if one or more layers of compliant material 110a, 110b are used, to contact the layer of compliant material 110a, 110b. The shim or shims 112a, 112b can be formed from stainless steel, which has a level of ductility, so that the area of impact on the beam 72 is distributed over an increased area, thereby reducing the loading pressure of the bump stop element 78, 80 to a level below that at which chipping of the beam 72 can occur, The shims 112a, 112b can be bonded to the beam 72 with glue.

It will be understood that in alternative embodiments, a layer of complaint material can be applied directly to the beam 72 without an associated shim, between a shim and the beam 72 or on a shim so as to be disposed between the shim and the associated bump stop element 78, 80.

The piezoelectric element can be manufactured in a rectangular shape for low cost and ease of manufacture. It can be bonded to a silicon beam either using epoxy resin or by eutectic bonding using an alloy of tin, bismuth and antimony as is commonly used for soldering. The piezoelectric element typically has a Curie temperature of about 300°C, so that a eutectic bonding process need to take place below this temperature. The temperature of the bonding process is the temperature at which stress is locked into the piezoelectric element and this can be substantial when the apparatus is brought to room temperature from the bonding temperature.

It will be understood that the apparatus for generation of electrical energy under centrifugal force can be used in a number of situations that require a node to wirelessly communicate with a central unit and the node requires an independent power source. For example, a monitor system for monitoring at least one parameter at the node can include a sensor device associated with the node that is electrically connected to the apparatus for generation of electrical energy under centrifugal force. The sensor device can include a measurement device arranged to measure one or more parameters and an associated transmitter arranged to transmit a signal indicative of the parameter determined by the measurement device. A receiver associated with the central unit is arranged to receive the signal from the transmitter.

In a more specific example, a tyre pressure monitoring systems can typically include a central processor for a vehicle wireless coupled to a sensor within one or more of the tyres of the vehicle. The sensor within the tyre can be powered by the apparatus for generation of electrical energy under centrifugal force so as to measure the pressure of the tyre and to transmit the measurement to the central processor via a transmitter. The pressure measurement provide by the sensor can be used by the central processor for applications wherein the pressure of the tyres will affect the performance or handling of the vehicle, for example electronic stability programme (ESP) or anti-lock brake systems (ABS). An alarm can also be provided to the operator of the vehicle if the pressure of a tyre is lower than a defined safe limit.

## Claims

1. An apparatus for generation of electrical energy under centrifugal force, including:
a support;
a beam attached at a first end to the support;
a loading mass attached to a distal end of the beam such that the loading mass is cantilevered with respect to the support;
a piezoelectric element attached to a surface of the beam; and
wherein the piezoelectric element is attached to the beam such that the piezoelectric element will be compressed by a centrifugal force applied to the loading mass.

2. An apparatus, as claimed in Claim 1, wherein a first bump stop element is arranged to contact the beam when the piezoelectric element is subjected to a predetermined compression force.

3. An apparatus, as claimed in Claim 2, wherein the first bump stop element is arranged to gradually contact the beam along the length of the beam with increasing compression force.

4. An apparatus, as claimed in Claim 2, wherein the first bump stop element includes two or more contact regions arranged to contact the beam along the length of the beam each at a different predetermined compression load.

5. An apparatus, as claimed in Claims 1 to 4, wherein a second bump stop element is arranged to contact the beam when the piezoelectric element is subjected to a predetermined tension force.

6. An apparatus, as claimed in Claim 5, wherein the second bump stop element is arranged to gradually contact the beam along the length of the beam with increasing tension force.

7. An apparatus, as claimed in Claim 5, wherein the second bump stop element includes two or more contact regions arranged to contact the beam along the length of the beam each at a different predetermined tension load.

8. An apparatus, as in Claims 5 to 7, wherein a gap between the second bump stop element and the beam is smaller than the gap between the first bump stop element and the beam.

9. An apparatus, as claimed in any of Claims 2 to 8, wherein the beam includes at least one shim carried thereon and the shim is arranged to contact the first and/or the second bump stop element.

10. An apparatus, as claimed in any of Claims 2 to 9, wherein the first and/or the second bump stop element includes a region of compliant material arranged to contact the beam.

11. An apparatus, as claimed in any of Claim 2 to 8, wherein the beam includes at least one region of compliant material arranged to contact the first and/or the second bump stop element.

12. An apparatus, as claimed in any preceding claim, wherein the beam is tapered between the first end and the distal end.

13. An apparatus, as claimed in any preceding claim, wherein the beam has a substantially T-shaped cross section.

14. An apparatus, as claimed in any preceding claim, wherein the piezoelectric element is tapered between the first end and the distal end.

15. An apparatus as claimed in any preceding claim arranged to be electrically connected to a tyre pressure monitoring system.

16. A monitor system for monitoring at least one parameter at a node remote from a central unit, including:
an apparatus for generation of electrical energy under centrifugal force according to any one of Claims 1 to 15;
a sensor device associated with the node and electrically connected to the apparatus for generation of electrical energy under centrifugal force that includes a measurement device arranged to measure the at least one parameter;
a transmitter arranged to transmit a signal indicative of the parameter determined by the measurement device; and
a receiver associated with the central unit arranged to receive the signal from the transmitter.
